# EUROPEAN PATENT APPLICATION

(11) **EP 4 496 007 A1**
(43) Date of publication of application: **22.01.2025**
(21) Application number: 23787356.7
(22) Date of filing: 09.01.2023
(51) Int. Cl.: H01L 29/51

(54) **FERROELECTRIC MEMORY CELL, MEMORY, AND ELECTRONIC DEVICE**

(30) Priority: 15.04.2022 CN 202210399194
(71) Applicant: Huawei Technologies Co., Ltd., Shenzhen, Guangdong 518129 (CN)
(72) Inventor: YU, Fangzhou, Shenzhen, Guangdong 518129 (CN); ZHANG, Heng, Shenzhen, Guangdong 518129 (CN); ZHANG, Yu, Shenzhen, Guangdong 518129 (CN); SUN, Yiming, Shenzhen, Guangdong 518129 (CN); LI, Yue, Shenzhen, Guangdong 518129 (CN); LV, Hangbing, Shenzhen, Guangdong 518129 (CN); XU, Jeffrey Junhao, Shenzhen, Guangdong 518129 (CN)
(74) Representative: Gill Jennings & Every LLP
(86) International application number: PCT/CN2023/071188
(87) International publication number: WO 2023/197707

(57) **Abstract**

Disclosed are a ferroelectric memory cell, a memory, and an electronic device. An oxygen blocking layer (05) and an oxygen storage layer (04) are introduced on one side of a ferroelectric layer (03), the oxygen storage layer (04) is adjacent to the ferroelectric layer (03), the oxygen storage layer (04) includes conductive oxide, the oxygen blocking layer (05) includes a conductive compound, and an electrical conductivity of the oxygen blocking layer (05) is greater than an electrical conductivity of the oxygen storage layer (04). The conductive oxide can reduce diffusion of oxygen atoms, and control a quantity of oxygen vacancies in a device to be not excessive, thereby reducing aggregation of the oxygen vacancies on a single-side electrode at a high temperature, and reducing device failure caused by a breakdown path generated when the oxygen vacancies are connected. The conductive compound can form close chemical bonds with diffused oxygen atoms, to prevent the oxygen atoms from further spreading into electrodes for diffusion, lock the oxygen atoms at an interface, and control a quantity of oxygen vacancies in a device to be not excessive, thereby reducing aggregation of the oxygen vacancies on a single-side electrode at a high temperature, and reducing device failure caused by a breakdown path generated when the oxygen vacancies are connected. This significantly improves high-temperature resistance and endurance of the ferroelectric memory cell.

## Description

### CROSS-REFERENCE TO RELATED APPLICATIONS

This application claims priority to Chinese Patent Application No. 202210399194.1, filed with the China National Intellectual Property Administration on April 15, 2022 and entitled "FERROELECTRIC MEMORY CELL, MEMORY, AND ELECTRONIC DEVICE", which is incorporated herein by reference in its entirety.

### TECHNICAL FIELD

This application relates to the field of memory technologies, and in particular, to a ferroelectric memory cell, a memory, and an electronic device.

### BACKGROUND

With rapid development of big data, internet, and internet of things, massive data is generated, so that a higher requirement is posed on performance of a data memory device. In a Von Neumann architecture, memories in a computer may be classified into an internal memory (for example, a dynamic random access memory (dynamic random access memory, DRAM)) that frequently exchanges data with a computing unit and an external memory (for example, a NAND flash memory) that is far away from the computing unit. The DRAM is featured in high-speed read/write, but is volatile and needs to be flushed frequently to keep data. The NAND flash memory is non-volatile, but has a low read/write speed and a small quantity of program/erase cycles. Therefore, in the current background, it is very urgent and important to find a new type of non-volatile memory device having a high read/write speed and low power consumption.

A ferroelectric random access memory (ferroelectric random access memory, FeRAM) is a new type of memory device. A core of the FeRAM is a metal-insulator-metal (metal-insulator-metal, MIM) capacitor structure including metal-ferroelectric-metal (metal-ferroelectric-metal, MFM). A principle of the FeRAM is a physical phenomenon that a ferroelectric dipole direction can be changed by an external electric field. When a ferroelectric material is used as an insulating dielectric material of an MFM capacitor, because an internal electric dipole direction is changed by the electric field, which causes the capacitor to be charged and discharged, under an action of a sense amplifier, microphysical phenomena can be identified to implement a memory state of "0" or "1". A dipole direction of the FeRAM can still be maintained after the external electric field is removed, and therefore the FeRAM is non-volatile. In addition, ferroelectric switching mainly comes from electric dipole switching. Because of a fast switching speed and low generated Joule heat, the FeRAM further has advantages of a fast read/write speed and low power consumption.

Currently, the ferroelectric material in the FeRAM is mainly a mixture Pb(Zr, Ti)O₃ of lead zirconate (PbZrO₃) and lead titanate (PbTiO₃), barium titanate (BaTiO₃), and other perovskite structure materials. However, due to existence of a critical thickness, this type of ferroelectric material needs to be at a specific thickness to show stable ferroelectricity, and therefore cannot be used in a device with an advanced process. This seriously limits further development and application of the ferroelectric material. A zirconium (Zr)-doped hafnium oxide (HfO₂) (that is, hafnium zirconium oxide (HZO))-based material has attracted much attention since being found to exhibit ferroelectricity. The ferroelectricity of the HZO-based ferroelectric material is derived from directional displacement of oxygen ions in a lattice. In addition, because the HZO-based ferroelectric material is compatible with a complementary metal oxide semiconductor (Complementary Metal Oxide Semiconductor, CMOS) process and the ferroelectricity can still be maintained at 10 nm, the HZO-based ferroelectric material is expected to be used in the new type of memory device to replace the DRAM, to achieve high density, a high speed, and low power consumption.

Compared with a conventional ferroelectric memory, an HZO memory still has some disadvantages, and needs to be further improved to improve high-temperature resistance and endurance (endurance) of the HZO memory. Especially, a defect of an interface between a metal electrode and the ferroelectric material, for example, an oxygen vacancy, may cause wakeup (wakeup), fatigue (fatigue), and breakdown effect in the HZO-based ferroelectric material. This is because the oxygen vacancy at the interface between the metal electrode and the ferroelectric material has a function of nailing on a ferroelectric domain in a preparation process, to suppress initial remnant polarization Pr. Nailing effect of the oxygen vacancy decreases with an increase of switching times, so that the remnant polarization Pr gradually increases. When polarization switching is further performed, the oxygen vacancy may prompt a nonferroelectric phase (M phase) to be converted into a ferroelectric phase (O phase), and the remnant polarization Pr further increases. However, during polarization switching, the oxygen ions in the HZO gradually depart and converge at the interface, so that the remnant polarization Pr starts to decrease, that is, fatigue effect. Finally, a large quantity of oxygen vacancies form a conductive path, causing device breakdown. Therefore, how to reduce oxygen vacancy concentration is a technical problem that urgently needs to be resolved by a person skilled in the art.

### SUMMARY

In view of this, this application provides a ferroelectric memory cell, a memory, and an electronic device, to reduce oxygen vacancy concentration in the ferroelectric memory cell.

According to a first aspect, this application provides a ferroelectric memory cell. At least one first oxygen blocking layer and at least one first oxygen storage layer are introduced at one side of a ferroelectric layer, to improve a structure of an interface between an electrode and the ferroelectric layer. The at least one first oxygen storage layer is adjacent to the ferroelectric layer. The first oxygen storage layer includes conductive oxide, and the first oxygen blocking layer includes a conductive compound. An electrical conductivity of the first oxygen blocking layer is greater than an electrical conductivity of the first oxygen storage layer. The at least one first oxygen blocking layer and the at least one first oxygen storage layer are introduced at the side of the ferroelectric layer. On the one hand, generation of an oxygen vacancy on the side of the ferroelectric layer can be reduced, a bias electric field generated at a high temperature is reduced, and high-temperature resistance is improved. On the other hand, an oxygen vacancy defect path is not prone to be formed on the side of the ferroelectric layer, probability of breakdown is reduced, and endurance reliability is improved. Therefore, easy breakdown of memory retention (retention) and endurance (endurance) can be effectively improved.

In a possible implementation, at least one second oxygen blocking layer and/or at least one second oxygen storage layer may be introduced at the other side of the ferroelectric layer, to improve a structure of an interface between an electrode and the ferroelectric layer. On the one hand, generation of an oxygen vacancy on the other side of the ferroelectric layer can be reduced, a bias electric field generated at a high temperature is reduced, and high-temperature resistance is improved. On the other hand, an oxygen vacancy defect path is not prone to be formed on the other side of the ferroelectric layer, probability of breakdown is reduced, and endurance reliability is improved. Therefore, easy breakdown of memory retention and endurance can be effectively improved. Specifically, the ferroelectric memory cell may include: the at least one second oxygen storage layer located on the other side of the ferroelectric layer; or the at least one second oxygen blocking layer located on the other side of the ferroelectric layer; or the at least one second oxygen blocking layer and at least one second oxygen blocking layer that are located on the other side of the ferroelectric layer, where the at least one second oxygen storage layer is adjacent to the ferroelectric layer. The second oxygen storage layer includes conductive oxide, and the second oxygen blocking layer includes a conductive compound. An electrical conductivity of the second oxygen blocking layer is greater than an electrical conductivity of the second oxygen storage layer.

For ease of description, the first oxygen storage layer and the second oxygen storage layer are collectively referred to as an oxygen storage layer below, and the first oxygen blocking layer and the second oxygen blocking layer are collectively referred to as a blockinglayer of oxygen.

This application proposes the ferroelectric memory cell that optimizes the interface by inserting the oxygen blocking layer and the oxygen storage layer. The ferroelectric memory cell may not only be used in an MFM structure, but also be used in another structure, for example, a metal-ferroelectric-insulator-semiconductor (metal-ferroelectric-insulator-semiconductor, MFIS) structure. Embodiments of this application may be applied to a scenario in which a ferroelectric memory needs to be frequently read/written in a high-temperature operating environment. The ferroelectric memory cell may be implemented in an intelligent terminal, for example, a mobile phone, a tablet, a computer, or another electronic device, to store and back up a program and data.

Specifically, the oxygen storage layer inserted into the ferroelectric memory cell may include conductive oxide. The conductive oxide can reduce diffusion of oxygen atoms in the ferroelectric layer, and control a quantity of oxygen vacancies in a device to be not excessive, thereby reducing aggregation of the oxygen vacancies on a single-side electrode at a high temperature, and reducing device failure caused by a breakdown path generated when the oxygen vacancies are connected. This significantly improves high-temperature resistance and endurance of the ferroelectric memory cell.

Specifically, the oxygen blocking layer inserted into the ferroelectric memory cell may include a conductive compound, and an electrical conductivity of the oxygen blocking layer is greater than an electrical conductivity of the oxygen storage layer. The conductive compound can form close chemical bonds with diffused oxygen atoms, to prevent the oxygen atoms from further spreading into electrodes for diffusion, lock the oxygen atoms at an interface, and control a quantity of oxygen vacancies in a device to be not excessive, thereby reducing aggregation of the oxygen vacancies on a single-side electrode at a high temperature, and reducing device failure caused by a breakdown path generated when the oxygen vacancies are connected. This significantly improves high-temperature resistance and endurance of the ferroelectric memory cell.

In a possible implementation, a resistivity of the oxygen blocking layer may be controlled in an order of magnitude of 1×10⁻⁷ Ω·m to 1×10⁻³ Ω·m, and a resistivity of the oxygen storage layer can be controlled in an order of magnitude of 1×10⁻⁴ Ω·m to 1×10⁴ Ω·m. It can be learned from comparison that the resistivity of the oxygen blocking layer is closer to a resistivity of metal, and the resistivity of the oxygen storage layer is slightly higher. However, compared with a true insulation layer (for example, silicon oxide (SiO₂) and hafnium oxide (HfO₂)) whose resistivity is far greater than 10¹⁰ Ω·m, the oxygen blocking layer and the oxygen storage layer each may be considered to have a conductive property. Because the inserted oxygen blocking layer and the inserted oxygen storage layer each have the conductive property, voltage division on the ferroelectric layer does not occur.

In a possible implementation, a material of the oxygen storage layer may include but is not limited to niobium oxide (Nb₂O₅ or NbO₂), ruthenium oxide (RuO₂), titanium oxide (TiO₂), or the like.

In a possible implementation, a material of the oxygen blocking layer may include but is not limited to tungsten nitride (WN), titanium nitride (TiN), tantalum nitride (TaN), or the like.

It should be noted that, because the electrical conductivity of the oxygen blocking layer is generally greater than the electrical conductivity of the oxygen storage layer, a conductive compound material that forms the oxygen blocking layer does not include a conductive oxide material that forms the oxygen storage layer.

In a possible implementation, a material of the ferroelectric layer may include but is not limited to at least one of hafnium oxide (HfO₂), zirconium oxide (ZrO₂), or hafnium zirconium oxide (HfZrO, HZO); or hafnium oxide, zirconium oxide, or hafnium zirconium oxide doped with at least one of La, Gd, Y, Al, Sr, Ce, or Ti.

In a possible implementation, the ferroelectric layer may specifically include: an alloy (alloy) structure of single-layer molecules of hafnium oxide and zirconium oxide, or a laminated (laminated) structure in which hafnium oxide and zirconium oxide are alternated, or a laminated structure in which Hf-rich hafnium zirconium oxide and Zr-rich hafnium zirconium oxide are alternated.

In a possible implementation, the ferroelectric memory cell may further include a first electrode (which may also be referred to as a top electrode or an upper electrode) and a second electrode (which may also be referred to as a bottom electrode or a lower electrode) that are disposed opposite to each other. The ferroelectric layer, the inserted oxygen storage layer, and the inserted oxygen blocking layer are all located between the first electrode and the second electrode.

In a possible implementation, materials of the first electrode and the second electrode may include but are not limited to tungsten (W), titanium (Ti), copper (Cu), aluminum (Al), ruthenium (Ru), platinum (Pt), iridium (Ir), tungsten nitride (WN), titanium nitride (TiN), tantalum nitride (TaN), and the like. The materials of the first electrode and the second electrode are generally conductive materials whose thermal expansion coefficients are greatly different from that of the material selected for the ferroelectric layer. The materials of the first electrode and the second electrode may be the same or different.

In a possible implementation, only the oxygen blocking layer may be inserted between the first electrode and the ferroelectric layer; or only the oxygen storage layer may be inserted between the first electrode and the ferroelectric layer; or both the oxygen blocking layer andthe oxygen storage layer that are stacked may be inserted between the first electrode and the ferroelectric layer. The oxygen storage layer is in contact with the ferroelectric layer, and the oxygen blocking layer is in contact with the first electrode.

In a possible implementation, only the oxygen blocking layer may be inserted between the second electrode and the ferroelectric layer; or only the oxygen storage layer may be disposed between the second electrode and the ferroelectric layer; or both the oxygen blocking layer and the oxygen storage layer that are stacked may be inserted between the second electrode and the ferroelectric layer. The oxygen storage layer is in contact with the ferroelectric layer, and the oxygen blocking layer is in contact with the second electrode.

In a possible implementation, the oxygen blocking layer and/or the oxygen storage layer may be inserted into two sides of the ferroelectric layer. In this way, it is not prone to form oxygen vacancy defect paths on the two sides of the ferroelectric layer, probability of breakdown is reduced, and endurance reliability is improved.

In a possible implementation, film layers inserted into the two sides of the ferroelectric layer may be symmetrically disposed. For example, both the oxygen storage layer and the oxygen blocking layer may be inserted into the two sides of the ferroelectric layer. Specifically, the second electrode, the oxygen blocking layer, the oxygen storage layer, the ferroelectric layer, the oxygen storage layer, the oxygen blocking layer, and the first electrode may be deposited in sequence in a thin film deposition manner, for example, physical vapor deposition (physical vapor deposition, PVD), chemical vapor deposition (chemical vapor deposition, CVD), or atomic layer deposition (atomic layer deposition, ALD), to obtain the ferroelectric memory cell. For another example, only oxygen storage layers may be inserted into the two sides of the ferroelectric layer. Specifically, the second electrode, the oxygen storage layer, the ferroelectric layer, the oxygen storage layer, and the first electrode may be deposited in sequence in a thin film deposition manner, for example, PVD, CVD, or ALD, to obtain the ferroelectric memory cell. For another example, only oxygen blocking layers may be inserted into the two sides of the ferroelectric layer. Specifically, the second electrode, the oxygen blocking layer, the ferroelectric layer, the oxygen blocking layer, and the first electrode may be deposited in sequence in a thin film deposition manner, for example, PVD, CVD, or ALD, to obtain the ferroelectric memory cell.

In a possible implementation, the film layers inserted into the two sides of the ferroelectric layer may alternatively be asymmetrically disposed. For example, the oxygen blocking layer and the oxygen storage layer may be inserted into the two sides of the ferroelectric layer respectively. Specifically, the second electrode, the oxygen blocking layer, the ferroelectric layer, the oxygen storage layer, and the first electrode may be deposited in sequence in a thin film deposition manner, for example, PVD, CVD, or ALD, to obtain the ferroelectric memory cell. Alternatively, the second electrode, the oxygen storage layer, the ferroelectric layer, the oxygen blocking layer, and the first electrode may be deposited in sequence in a thin film deposition manner, for example, PVD, CVD, or ALD, to obtain the ferroelectric memory cell. For another example, both the oxygen blocking layer and the oxygen storage layer may be inserted into one side that is of the ferroelectric layer and that is close to the first electrode, and only the oxygen blocking layer or the oxygen storage layer is inserted into one side that is of the ferroelectric layer and that is close to the second electrode. Specifically, the second electrode, the oxygen blocking layer, the ferroelectric layer, the oxygen storage layer, the oxygen blocking layer, and the first electrode may be deposited in sequence in a thin film deposition manner, for example, PVD, CVD, or ALD, to obtain the ferroelectric memory cell. Alternatively, the second electrode, the oxygen storage layer, the ferroelectric layer, the oxygen storage layer, the oxygen blocking layer, and the first electrode may be deposited in sequence in a thin film deposition manner, for example, PVD, CVD, or ALD, to obtain the ferroelectric memory cell. For another example, both the oxygen blocking layer and the oxygen storage layer may be inserted into one side that is of the ferroelectric layer and that is close to the second electrode, and only the oxygen blocking layer or the oxygen storage layer may be inserted into one side that is of the ferroelectric layer and that is close to the first electrode. Specifically, the second electrode, the oxygen blocking layer, the oxygen storage layer, the ferroelectric layer, the oxygen blocking layer, and the first electrode may be deposited in sequence in a thin film deposition manner, for example, PVD, CVD, or ALD, to obtain the ferroelectric memory cell. Alternatively, the second electrode, the oxygen blocking layer, the oxygen storage layer, the ferroelectric layer, the oxygen storage layer, and the first electrode may be deposited in sequence in a thin film deposition manner, for example, PVD, CVD, or ALD, to obtain the ferroelectric memory cell.

In a possible implementation, the oxygen blocking layer and/or the oxygen storage layer may be inserted only into a single-side of the ferroelectric layer. In this way, it is not prone to form an oxygen vacancy defect path on the side of the ferroelectric layer, probability of breakdown may further be reduced, and endurance reliability is improved. For example, both the oxygen blocking layer and the oxygen storage layer may be inserted into the side of the ferroelectric layer. Specifically, the second electrode, the ferroelectric layer, the oxygen storage layer, the oxygen blocking layer, and the first electrode may be deposited in sequence in a thin film deposition manner, for example, PVD, CVD, or ALD, to obtain the ferroelectric memory cell. Alternatively, the second electrode, the oxygen blocking layer, the oxygen storage layer, the ferroelectric layer, and the first electrode may be deposited in sequence in a thin film deposition manner, for example, PVD, CVD, or ALD, to obtain the ferroelectric memory cell. For another example, only the oxygen storage layer may be inserted into the side of the ferroelectric layer. Specifically, the second electrode, the ferroelectric layer, the oxygen storage layer, and the first electrode may be deposited in sequence in a thin film deposition manner, for example, PVD, CVD, or ALD, to obtain the ferroelectric memory cell. Alternatively, the second electrode, the oxygen storage layer, the ferroelectric layer, and the first electrode may be deposited in sequence in a thin film deposition manner, for example, PVD, CVD, or ALD, to obtain the ferroelectric memory cell. For another example, only the oxygen blocking layer may be inserted into the side of the ferroelectric layer. Specifically, the second electrode, the ferroelectric layer, the oxygen blocking layer, and the first electrode may be deposited in sequence in a thin film deposition manner, for example, PVD, CVD, or ALD, to obtain the ferroelectric memory cell. Alternatively, the second electrode, the oxygen blocking layer, the ferroelectric layer, and the first electrode may be deposited in sequence in a thin film deposition manner, for example, PVD, CVD, or ALD, to obtain the ferroelectric memory cell.

In a possible implementation, because the resistivity of the oxygen blocking layer is closer to the resistivity of the metal, the oxygen blocking layer that is reused as an electrode is disposed on at least one side of the ferroelectric layer, that is, the first electrode and/or the second electrode are discarded, and the electrode is replaced with the conductive property of the oxygen blocking layer.

In a possible implementation, when oxygen blocking layers are inserted into the two sides of the ferroelectric layer, the oxygen blocking layers may replace the first electrode and the second electrode. For example, the film layers inserted into the two sides of the ferroelectric layer may be symmetrically disposed. Specifically, the oxygen blocking layer, the oxygen storage layer, the ferroelectric layer, the oxygen storage layer, and the oxygen blocking layer may be deposited in sequence in a thin film deposition manner, for example, PVD, CVD, or ALD, to obtain the ferroelectric memory cell. Alternatively, the oxygen blocking layer, the ferroelectric layer, and the oxygen blocking layer may be deposited in sequence in a thin film deposition manner, for example, PVD, CVD, or ALD, to obtain the ferroelectric memory cell. For another example, the film layers inserted into the two sides of the ferroelectric layer may be asymmetrically disposed. Specifically, the oxygen blocking layer, the ferroelectric layer, the oxygen storage layer, and the oxygen blocking layer may be deposited in sequence in a thin film deposition manner, for example, PVD, CVD, or ALD, to obtain the ferroelectric memory cell. Alternatively, the oxygen blocking layer, the oxygen storage layer, the ferroelectric layer, and the oxygen blocking layer may be deposited in sequence in a thin film deposition manner, for example, PVD, CVD, or ALD, to obtain the ferroelectric memory cell.

In a possible implementation, the oxygen blocking layer inserted into the side that is of the ferroelectric layer and that is close to the first electrode may replace the first electrode. For example, the oxygen blocking layer may also be inserted into the side that is of the ferroelectric layer and that is close to the second electrode, but the second electrode may be disposed at the same time. Specifically, the second electrode, the oxygen blocking layer, the oxygen storage layer, the ferroelectric layer, the oxygen storage layer, and the oxygen blocking layer may be deposited in sequence in a thin film deposition manner, for example, PVD, CVD, or ALD, to obtain the ferroelectric memory cell. Alternatively, the second electrode, the oxygen blocking layer, the oxygen storage layer, the ferroelectric layer, and the oxygen blocking layer may be deposited in sequence in a thin film deposition manner, for example, PVD, CVD, or ALD, to obtain the ferroelectric memory cell. Alternatively, the second electrode, the oxygen blocking layer, the ferroelectric layer, the oxygen storage layer, and the oxygen blocking layer may be deposited in sequence in a thin film deposition manner, for example, PVD, CVD, or ALD, to obtain the ferroelectric memory cell. Alternatively, the second electrode, the oxygen blocking layer, the ferroelectric layer, and the oxygen blocking layer may be deposited in sequence in a thin film deposition manner, for example, PVD, CVD, or ALD, to obtain the ferroelectric memory cell. For another example, the oxygen blocking layer may not be inserted into the side that is of the ferroelectric layer and that is close to the second electrode. Specifically, the second electrode, the oxygen storage layer, the ferroelectric layer, the oxygen storage layer, and the oxygen blocking layer may be deposited in sequence in a thin film deposition manner, for example, PVD, CVD, or ALD, to obtain the ferroelectric memory cell. Alternatively, the second electrode, the oxygen storage layer, the ferroelectric layer, and the oxygen blocking layer may be deposited in sequence in a thin film deposition manner, for example, PVD, CVD, or ALD, to obtain the ferroelectric memory cell. Alternatively, the second electrode, the ferroelectric layer, the oxygen storage layer, and the oxygen blocking layer may be deposited in sequence in a thin film deposition manner, for example, PVD, CVD, or ALD, to obtain the ferroelectric memory cell. Alternatively, the second electrode, the ferroelectric layer, and the oxygen blocking layer may be deposited in sequence in a thin film deposition manner, for example, PVD, CVD, or ALD, to obtain the ferroelectric memory cell.

In a possible implementation, the oxygen blocking layer inserted into the side that is of the ferroelectric layer and that is close to the second electrode may replace the second electrode. For example, the oxygen blocking layer may also be inserted into the side that is of the ferroelectric layer and that is close to the first electrode, but the first electrode may be disposed at the same time. Specifically, the oxygen blocking layer, the oxygen storage layer, the ferroelectric layer, the oxygen storage layer, the oxygen blocking layer, and the first electrode may be deposited in sequence in a thin film deposition manner, for example, PVD, CVD, or ALD, to obtain the ferroelectric memory cell. Alternatively, the oxygen blocking layer, the oxygen storage layer, the ferroelectric layer, the oxygen blocking layer, and the first electrode may be deposited in sequence in a thin film deposition manner, for example, PVD, CVD, or ALD, to obtain the ferroelectric memory cell. Alternatively, the oxygen blocking layer, the ferroelectric layer, the oxygen storage layer, the oxygen blocking layer, and the first electrode may be deposited in sequence in a thin film deposition manner, for example, PVD, CVD, or ALD, to obtain the ferroelectric memory cell. Alternatively, the oxygen blocking layer, the ferroelectric layer, the oxygen blocking layer, and the first electrode may be deposited in sequence in a thin film deposition manner, for example, PVD, CVD, or ALD, to obtain the ferroelectric memory cell. For another example, the oxygen blocking layer may not be inserted into the side that is of the ferroelectric layer and that is close to the first electrode. Specifically, the oxygen blocking layer, the oxygen storage layer, the ferroelectric layer, the oxygen storage layer, and the first electrode may be deposited in sequence in a thin film deposition manner, for example, PVD, CVD, or ALD, to obtain the ferroelectric memory cell. Alternatively, the oxygen blocking layer, the oxygen storage layer, the ferroelectric layer, and the first electrode may be deposited in sequence in a thin film deposition manner, for example, PVD, CVD, or ALD, to obtain the ferroelectric memory cell. Alternatively, the oxygen blocking layer, the ferroelectric layer, the oxygen storage layer, and the first electrode may be deposited in sequence in a thin film deposition manner, for example, PVD, CVD, or ALD, to obtain the ferroelectric memory cell. Alternatively, the oxygen blocking layer, the ferroelectric layer, and the first electrode may be deposited in sequence in a thin film deposition manner, for example, PVD, CVD, or ALD, to obtain the ferroelectric memory cell.

According to a second aspect, an embodiment of this application further provides a memory, including a control circuit and a plurality of ferroelectric memory cells according to the first aspect or the implementations of the first aspect. The control circuit is electrically connected to each ferroelectric memory cell. Specifically, a voltage may be applied to the ferroelectric memory cell via the control circuit, to control the ferroelectric memory cell to implement a read/write operation.

According to a third aspect, an embodiment of this application further provides an electronic device, including a circuit board and the memory that is coupled to the circuit board and that is provided in the implementation of the second aspect. The electronic device may be an electronic device, for example, a mobile phone, a tablet computer, a notebook computer, a wearable device, or an in-vehicle device, or certainly may be another electronic device. This is not limited herein.

For technical effect that can be achieved in the second aspect and the third aspect, refer to the descriptions of technical effect that can be achieved in any one of the possible designs in the first aspect. Details are not described herein again.

### BRIEF DESCRIPTION OF DRAWINGS

FIG. 1 is a diagram of a cross-sectional structure of an existing ferroelectric memory cell;
FIG. 2 is a diagram of a cross-sectional structure of a ferroelectric memory cell according to an embodiment of this application;
FIG. 3 is a diagram of another cross-sectional structure of a ferroelectric memory cell according to an embodiment of this application;
FIG. 4 is a diagram of still another cross-sectional structure of a ferroelectric memory cell according to an embodiment of this application;
FIG. 5 is a diagram of still another cross-sectional structure of a ferroelectric memory cell according to an embodiment of this application;
FIG. 6 is a diagram of still another cross-sectional structure of a ferroelectric memory cell according to an embodiment of this application;
FIG. 7 is a diagram of still another cross-sectional structure of a ferroelectric memory cell according to an embodiment of this application;
FIG. 8 is a diagram of still another cross-sectional structure of a ferroelectric memory cell according to an embodiment of this application;
FIG. 9 is a diagram of still another cross-sectional structure of a ferroelectric memory cell according to an embodiment of this application;
FIG. 10 is a diagram of still another cross-sectional structure of a ferroelectric memory cell according to an embodiment of this application;
FIG. 11 is a diagram of still another cross-sectional structure of a ferroelectric memory cell according to an embodiment of this application;
FIG. 12 is a diagram of still another cross-sectional structure of a ferroelectric memory cell according to an embodiment of this application;
FIG. 13 is a diagram of still another cross-sectional structure of a ferroelectric memory cell according to an embodiment of this application;
FIG. 14 is a diagram of still another cross-sectional structure of a ferroelectric memory cell according to an embodiment of this application;
FIG. 15 is a diagram of still another cross-sectional structure of a ferroelectric memory cell according to an embodiment of this application;
FIG. 16 is a diagram of still another cross-sectional structure of a ferroelectric memory cell according to an embodiment of this application;
FIG. 17 is a diagram of still another cross-sectional structure of a ferroelectric memory cell according to an embodiment of this application;
FIG. 18 is a diagram of still another cross-sectional structure of a ferroelectric memory cell according to an embodiment of this application;
FIG. 19 is a diagram of still another cross-sectional structure of a ferroelectric memory cell according to an embodiment of this application;
FIG. 20 is a diagram of still another cross-sectional structure of a ferroelectric memory cell according to an embodiment of this application;
FIG. 21 is a diagram of still another cross-sectional structure of a ferroelectric memory cell according to an embodiment of this application;
FIG. 22 is a diagram of still another cross-sectional structure of a ferroelectric memory cell according to an embodiment of this application;
FIG. 23 is a diagram of still another cross-sectional structure of a ferroelectric memory cell according to an embodiment of this application;
FIG. 24 is a diagram of still another cross-sectional structure of a ferroelectric memory cell according to an embodiment of this application;
FIG. 25 is a diagram of still another cross-sectional structure of a ferroelectric memory cell according to an embodiment of this application;
FIG. 26 is a diagram of still another cross-sectional structure of a ferroelectric memory cell according to an embodiment of this application;
FIG. 27 is a diagram of still another cross-sectional structure of a ferroelectric memory cell according to an embodiment of this application;
FIG. 28 is a diagram of still another cross-sectional structure of a ferroelectric memory cell according to an embodiment of this application;
FIG. 29 is a diagram of still another cross-sectional structure of a ferroelectric memory cell according to an embodiment of this application;
FIG. 30 is a diagram of still another cross-sectional structure of a ferroelectric memory cell according to an embodiment of this application;
FIG. 31 is a diagram of still another cross-sectional structure of a ferroelectric memory cell according to an embodiment of this application;
FIG. 32 is a diagram of still another cross-sectional structure of a ferroelectric memory cell according to an embodiment of this application;
FIG. 33 is a diagram of still another cross-sectional structure of a ferroelectric memory cell according to an embodiment of this application;
FIG. 34 is a diagram of still another cross-sectional structure of a ferroelectric memory cell according to an embodiment of this application;
FIG. 35 is a diagram of still another cross-sectional structure of a ferroelectric memory cell according to an embodiment of this application;
FIG. 36 is a diagram of still another cross-sectional structure of a ferroelectric memory cell according to an embodiment of this application;
FIG. 37 is a diagram of a structure of a ferroelectric layer in a ferroelectric memory cell according to an embodiment of this application; and
FIG. 38 is a diagram of another structure of a ferroelectric layer in a ferroelectric memory cell according to an embodiment of this application.

Descriptions of reference numerals:
01-first electrode, 02-second electrode, 03-ferroelectric layer, 04-oxygen storage layer, 05-oxygen blocking layer.

### DESCRIPTION OF EMBODIMENTS

To make the objectives, technical solutions, and advantages of this application clearer, the following further describes this application in detail with reference to the accompanying drawings.

It should be noted that, in this specification, similar reference numerals and letters in the following accompanying drawings indicate similar items. Therefore, once an item is defined in an accompanying drawing, the item does not need to be further defined or interpreted in following accompanying drawings.

In the descriptions of this application, it should be noted that, directions or location relationships indicated by terms such as "center", "up", "down", "left", "right", "vertical", "horizontal", "inside", and "outside" are based on the directions or location relationships shown in the accompanying drawings, and are merely intended to describe this application and simplify the descriptions, but are not intended to indicate or imply that an indicated apparatus or element needs to have a specific direction or be constructed and operated in a specific direction, and therefore cannot be understood as a limitation on this application. Expressions of locations and directions described in this application are all described by using the accompanying drawings as an example, but changes may be made as required, and the changes fall within the protection scope of the present invention. The accompanying drawings in this application are merely used to illustrate relative position relationships and do not represent an actual scale. In addition, terms "first" and "second" are merely used for a purpose of description, and shall not be understood as an indication or implication of relative importance.

To facilitate understanding of the technical solutions provided in embodiments of this application, the following describes an application scenario of the technical solutions. A memory cell is a smallest unit that has a data storage and read/write function in a memory, and may be configured to store a smallest information unit, namely, 1-bit data (for example, 0 or 1), namely, a binary digit. A plurality of pieces of binary-digit data may be stored via a plurality of memory cells. Specifically, in embodiments of this application, one memory cell is configured to store one binary digit. The memory provided in this application may be configured to store data in an electronic device, for example, a mobile phone, a tablet computer, a notebook computer, a wearable device, or an in-vehicle device, or certainly may be used in another electronic device. This is not limited herein.

The following describes a ferroelectric memory cell, a memory, and an electronic device in the technical solutions of this application with reference to the accompanying drawings.

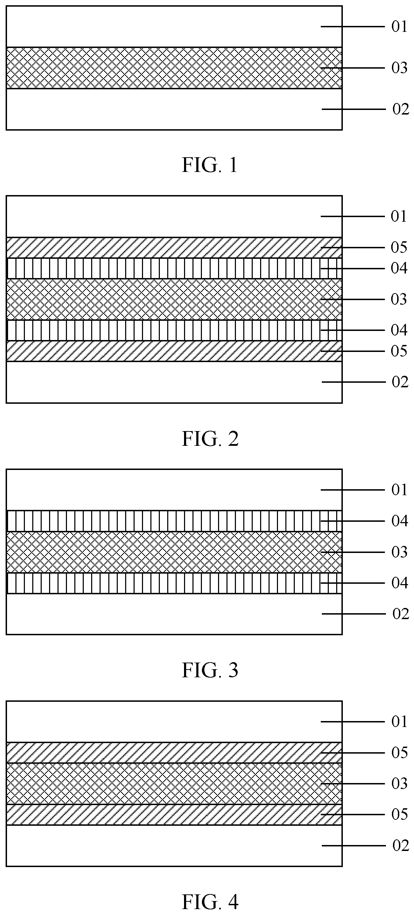

FIG. 1 is an example of a diagram of a cross-sectional structure of an existing ferroelectric memory cell. Refer to FIG. 1. The existing ferroelectric memory cell includes a first electrode 01 (which may also be referred to as a top electrode or an upper electrode), a second electrode 02 (which may also be referred to as a bottom electrode or a lower electrode), and a ferroelectric layer 03 that is located between the first electrode 01 and the second electrode 02 and that is in direct contact with the electrodes. In a process of using the ferroelectric memory cell, oxygen atoms are prone to diffuse from the ferroelectric layer 03 to the electrodes, resulting in more oxygen vacancy defects generated in the ferroelectric layer 03.

Based on this, an embodiment of this application provides a ferroelectric memory cell. At least one first oxygen blocking layer and at least one first oxygen storage layer are introduced at one side of a ferroelectric layer, to improve a structure of an interface between an electrode and the ferroelectric layer. The at least one first oxygen storage layer is adjacent to the ferroelectric layer. The first oxygen storage layer includes conductive oxide, and the first oxygen blocking layer includes a conductive compound. An electrical conductivity of the first oxygen blocking layer is greater than an electrical conductivity of the first oxygen storage layer. The at least one first oxygen blocking layer and the at least one first oxygen storage layer are introduced at the side of the ferroelectric layer. On the one hand, generation of an oxygen vacancy on the side of the ferroelectric layer can be reduced, a bias electric field generated at a high temperature is reduced, and high-temperature resistance is improved. On the other hand, an oxygen vacancy defect path is not prone to be formed on the side of the ferroelectric layer, probability of breakdown is reduced, and endurance reliability is improved. Therefore, easy breakdown of memory retention (retention) and endurance (endurance) can be effectively improved.

In an embodiment of this application, at least one second oxygen blocking layer and/or at least one second oxygen storage layer may be introduced at the other side of the ferroelectric layer, to improve a structure of an interface between an electrode and the ferroelectric layer. On the one hand, generation of an oxygen vacancy on the other side of the ferroelectric layer can be reduced, a bias electric field generated at a high temperature is reduced, and high-temperature resistance is improved. On the other hand, an oxygen vacancy defect path is not prone to be formed on the other side of the ferroelectric layer, probability of breakdown is reduced, and endurance reliability is improved. Therefore, easy breakdown of memory retention and endurance can be effectively improved. Specifically, the ferroelectric memory cell may include: the at least one second oxygen storage layer located on the other side of the ferroelectric layer; or the at least one second oxygen blocking layer located on the other side of the ferroelectric layer; or the at least one second oxygen blocking layer and at least one second oxygen blocking layer that are located on the other side of the ferroelectric layer, where the at least one second oxygen storage layer is adjacent to the ferroelectric layer. The second oxygen storage layer includes conductive oxide, and the second oxygen blocking layer includes a conductive compound. An electrical conductivity of the second oxygen blocking layer is greater than an electrical conductivity of the second oxygen storage layer.

For ease of description, the first oxygen storage layer and the second oxygen storage layer are collectively referred to as an oxygen storage layer in the following, and the first oxygen blocking layer and the second oxygen blocking layer are collectively referred to as an oxygen storage layer.

This application proposes the ferroelectric memory cell that optimizes the interface by inserting the oxygen blocking layer and/or the oxygen storage layer. The ferroelectric memory cell may not only be used in an MFM structure, but also be used in another structure, for example, a metal-ferroelectric-insulator-semiconductor (metal-ferroelectric-insulator-semiconductor, MFIS) structure. Embodiments of this application may be applied to a scenario in which a ferroelectric memory needs to be frequently read/written in a high-temperature operating environment. The ferroelectric memory cell may be implemented in an intelligent terminal, for example, a mobile phone, a tablet, a computer, or another electronic device, to store and back up a program and data.

FIG. 2 to FIG. 36 show examples of diagrams of cross-sectional structures of various ferroelectric memory cells respectively according to embodiments of this application. Refer to FIG. 2 to FIG. 36. An oxygen storage layer 04 inserted into the ferroelectric memory cell may include conductive oxide. The conductive oxide can reduce diffusion of oxygen atoms in the ferroelectric layer 03, and control a quantity of oxygen vacancies in a device to be not excessive, thereby reducing aggregation of the oxygen vacancies on a single-side electrode at a high temperature, and reducing device failure caused by a breakdown path generated when the oxygen vacancies are connected. This significantly improves high-temperature resistance and endurance of the ferroelectric memory cell.

Specifically, an oxygen blocking layer 05 inserted into the ferroelectric memory cell may include a conductive compound, and an electrical conductivity of the oxygen blocking layer 05 is greater than an electrical conductivity of the oxygen storage layer 04. The conductive compound can form close chemical bonds with diffused oxygen atoms, to prevent the oxygen atoms from further spreading into electrodes for diffusion, lock the oxygen atoms at an interface, and control a quantity of oxygen vacancies in a device to be not excessive, thereby reducing aggregation of the oxygen vacancies on a single-side electrode at a high temperature, and reducing device failure caused by a breakdown path generated when the oxygen vacancies are connected. This significantly improves high-temperature resistance and endurance of the ferroelectric memory cell.

In an embodiment of this application, a resistivity of the oxygen blocking layer 05 may be controlled in an order of magnitude of 1×10⁻⁷ Ω·m to 1×10⁻³ Ω·m, and a resistivity of the oxygen storage layer 04 can be controlled in an order of magnitude of 1×10⁻⁴ Ω·m to 1×10⁴ Ω·m. It can be learned from comparison that the resistivity of the oxygen blocking layer 05 is closer to a resistivity of metal, and the resistivity of the oxygen storage layer 04 is slightly higher. However, compared with a true insulation layer (for example, silicon oxide (SiO₂) and hafnium oxide (HfO₂)) whose resistivity is far greater than 10¹⁰ Ω·m, the oxygen blocking layer 05 and the oxygen storage layer 04 each may be considered to have a conductive property. Because the inserted oxygen blocking layer 05 and the inserted oxygen storage layer 04 each have the conductive property, voltage division on the ferroelectric layer 03 does not occur.

In an embodiment of this application, a material of the oxygen storage layer 04 may include but is not limited to niobium oxide (Nb₂O₅ or NbO₂), ruthenium oxide (RuO₂), titanium oxide (TiO₂), or the like.

In an embodiment of this application, a material of the oxygen blocking layer 05 may include but is not limited to tungsten nitride (WN), titanium nitride (TiN), tantalum nitride (TaN), or the like.

It should be noted that, because the electrical conductivity of the oxygen blocking layer 05 is generally greater than the electrical conductivity of the oxygen storage layer 04, a conductive compound material that forms the oxygen blocking layer 05 does not include a conductive oxide material that forms the oxygen storage layer 04.

In an embodiment of this application, a material of the ferroelectric layer 03 may include but is not limited to at least one of hafnium oxide (HfO₂), zirconium oxide (ZrO₂), or hafnium zirconium oxide (HfZrO, HZO); or hafnium oxide, zirconium oxide, or hafnium zirconium oxide doped with at least one of La, Gd, Y, Al, Sr, Ce, or Ti.

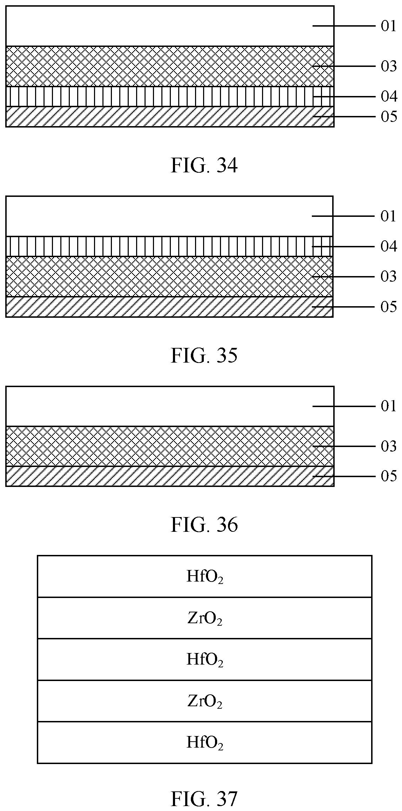

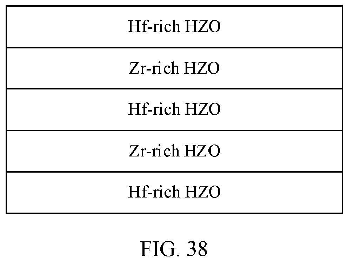

FIG. 37 is an example of a diagram of a structure of a ferroelectric layer 03 in a ferroelectric memory cell according to an embodiment of this application. FIG. 38 is an example of a diagram of another structure of a ferroelectric layer 03 in a ferroelectric memory cell according to an embodiment of this application. In an embodiment of this application, the ferroelectric layer 03 may specifically include: an alloy (alloy) structure of single-layer molecules of hafnium oxide and zirconium oxide, or as shown in FIG. 37, a laminated (laminated) structure in which hafnium oxide and zirconium oxide are alternated, or as shown in FIG. 38, a laminated structure in which Hf-rich hafnium zirconium oxide and Zr-rich hafnium zirconium oxide are alternated.

Refer to FIG. 2 to FIG. 16. In an embodiment of this application, the ferroelectric memory cell may further include a first electrode 01 (which may also be referred to as a top electrode or an upper electrode) and a second electrode 02 (which may also be referred to as a bottom electrode or a lower electrode) that are disposed opposite to each other. The ferroelectric layer 03, the inserted oxygen storage layer 04, and the inserted oxygen blocking layer 05 are all located between the first electrode 01 and the second electrode 02.

In an embodiment of this application, materials of the first electrode 01 and the second electrode 02 may include but are not limited to tungsten (W), titanium (Ti), copper (Cu), aluminum (Al), ruthenium (Ru), platinum (Pt), iridium (Ir), tungsten nitride (WN), titanium nitride (TiN), tantalum nitride (TaN), and the like. The materials of the first electrode 01 and the second electrode 02 are generally conductive materials whose thermal expansion coefficients are greatly different from that of the material selected for the ferroelectric layer 03. The materials of the first electrode 01 and the second electrode 02 may be the same or different.

In an embodiment of this application, as shown in FIG. 4, FIG. 6, FIG. 9, and FIG. 15, only the oxygen blocking layer 05 may be inserted between the first electrode 01 and the ferroelectric layer 03; or as shown in FIG. 3, FIG. 5, FIG. 10, and FIG. 13, only the oxygen storage layer 04 may be inserted between the first electrode 01 and the ferroelectric layer 03; or as shown in FIG. 2, FIG. 7, FIG. 8, and FIG. 11, both the oxygen blocking layer 05 or the oxygen storage layer 04 that are stacked may be inserted between the first electrode 01 and the ferroelectric layer 03. The oxygen storage layer 04 is in contact with the ferroelectric layer 03, and the oxygen blocking layer 05 is in contact with the first electrode 01.

In an embodiment of this application, as shown in FIG. 4, FIG. 5, FIG. 7, and FIG. 16, only the oxygen blocking layer 05 may be inserted between the second electrode 02 and the ferroelectric layer 03; or as shown in FIG. 3, FIG. 6, FIG. 8, and FIG. 14, only the oxygen storage layer 04 may be disposed between the second electrode 02 and the ferroelectric layer 03; or as shown in FIG. 2, FIG. 9, FIG. 10, and FIG. 12, both the oxygen blocking layer 05 and the oxygen storage layer 04 that are stacked may be inserted between the second electrode 02 and the ferroelectric layer 03. The oxygen storage layer 04 is in contact with the ferroelectric layer 03, and the oxygen blocking layer 05 is in contact with the second electrode 02.

Refer to FIG. 2 to FIG. 10. In an embodiment of this application, the oxygen blocking layer 05 and/or the oxygen storage layer 04 may be inserted into two sides of the ferroelectric layer 03. In this way, it is not prone to form oxygen vacancy defect paths on the two sides of the ferroelectric layer 03, probability of breakdown is reduced, and endurance reliability is improved.

Refer to FIG. 2 to FIG. 4. In an embodiment of this application, film layers inserted into the two sides of the ferroelectric layer 03 may be symmetrically disposed. For example, as shown in FIG. 2, both the oxygen storage layer 04 and the oxygen blocking layer 05 may be inserted into the two sides of the ferroelectric layer 03. Specifically, the second electrode 02, the oxygen blocking layer 05, the oxygen storage layer 04, the ferroelectric layer 03, the oxygen storage layer 04, the oxygen blocking layer 05, and the first electrode 01 may be deposited in sequence in a thin film deposition manner, for example, physical vapor deposition (physical vapor deposition, PVD), chemical vapor deposition (chemical vapor deposition, CVD), or atomic layer deposition (atomic layer deposition, ALD), to obtain the ferroelectric memory cell. For another example, as shown in FIG. 3, only oxygen storage layers 04 may be inserted into the two sides of the ferroelectric layer 03. Specifically, the second electrode 02, the oxygen storage layer 04, the ferroelectric layer 03, the oxygen storage layer 04, and the first electrode 01 may be deposited in sequence in a thin film deposition manner, for example, PVD, CVD, or ALD, to obtain the ferroelectric memory cell. For another example, as shown in FIG. 4, only oxygen blocking layers 05 may be inserted into the two sides of the ferroelectric layer 03. Specifically, the second electrode 02, the oxygen blocking layer 05, the ferroelectric layer 03, the oxygen blocking layer 05, and the first electrode 01 may be deposited in sequence in a thin film deposition manner, for example, PVD, CVD, or ALD, to obtain the ferroelectric memory cell.

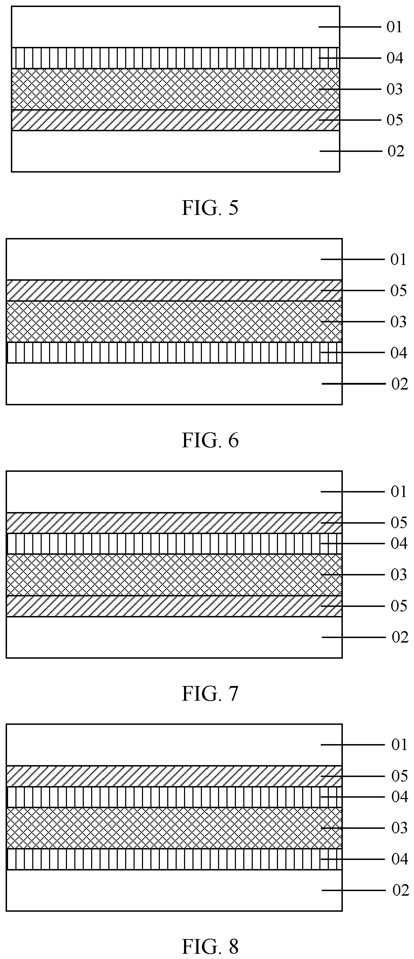

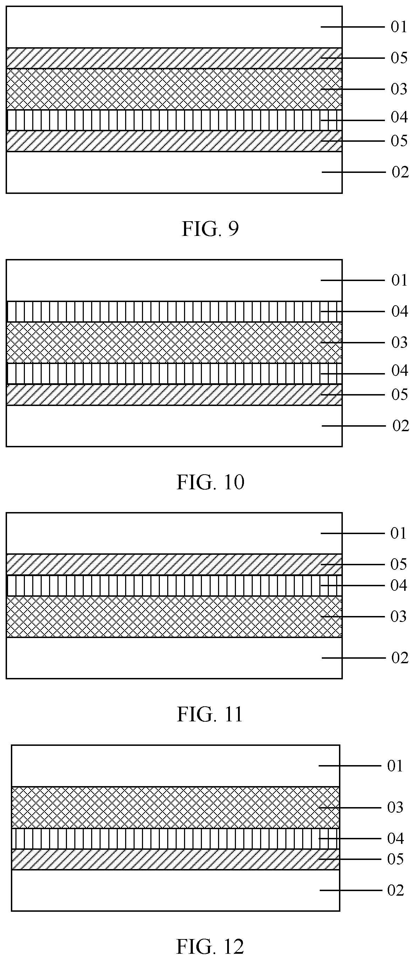

Refer to FIG. 5 to FIG. 10. In an embodiment of this application, the film layers inserted into the two sides of the ferroelectric layer 03 may alternatively be asymmetrically disposed. For example, as shown in FIG. 5 and FIG. 6, the oxygen blocking layer 05 and the oxygen storage layer 04 may be inserted into the two sides of the ferroelectric layer 03 respectively. Specifically, the second electrode 02, the oxygen blocking layer 05, the ferroelectric layer 03, the oxygen storage layer 04, and the first electrode 01 may be deposited in sequence in a thin film deposition manner, for example, PVD, CVD, or ALD, to obtain the ferroelectric memory cell as shown in FIG. 5. Alternatively, the second electrode 02, the oxygen storage layer 04, the ferroelectric layer 03, the oxygen blocking layer 05, and the first electrode 01 may be deposited in sequence in a thin film deposition manner, for example, PVD, CVD, or ALD, to obtain the ferroelectric memory cell as shown in FIG. 6. For another example, as shown in FIG. 7 and FIG. 8, both the oxygen blocking layer 05 and the oxygen storage layer 04 may be inserted into one side that is of the ferroelectric layer 03 and that is close to the first electrode 01, and only the oxygen blocking layer 05 or the oxygen storage layer 04 is inserted into one side that is of the ferroelectric layer 03 and that is close to the second electrode 02. Specifically, the second electrode 02, the oxygen blocking layer 05, the ferroelectric layer 03, the oxygen storage layer 04, the oxygen blocking layer 05, and the first electrode 01 may be deposited in sequence in a thin film deposition manner, for example, PVD, CVD, or ALD, to obtain the ferroelectric memory cell as shown in FIG. 7. Alternatively, the second electrode 02, the oxygen storage layer 04, the ferroelectric layer 03, the oxygen storage layer 04, the oxygen blocking layer 05, and the first electrode 01 may be deposited in sequence in a thin film deposition manner, for example, PVD, CVD, or ALD, to obtain the ferroelectric memory cell as shown in FIG. 8. For another example, as shown in FIG. 9 and FIG. 10, both the oxygen blocking layer 05 and the oxygen storage layer 04 may be inserted into one side that is of the ferroelectric layer 03 and that is close to the second electrode 02, and only the oxygen blocking layer 05 or the oxygen storage layer 04 is inserted into one side that is of the ferroelectric layer 03 and that is close to the first electrode 01. Specifically, the second electrode 02, the oxygen blocking layer 05, the oxygen storage layer 04, the ferroelectric layer 03, the oxygen blocking layer 05, and the first electrode 01 may be deposited in sequence in a thin film deposition manner, for example, PVD, CVD, or ALD, to obtain the ferroelectric memory cell as shown in FIG. 9. Alternatively, the second electrode 02, the oxygen blocking layer 05, the oxygen storage layer 04, the ferroelectric layer 03, the oxygen storage layer 04, and the first electrode 01 may be deposited in sequence in a thin film deposition manner, for example, PVD, CVD, or ALD, to obtain the ferroelectric memory cell as shown in FIG. 10.

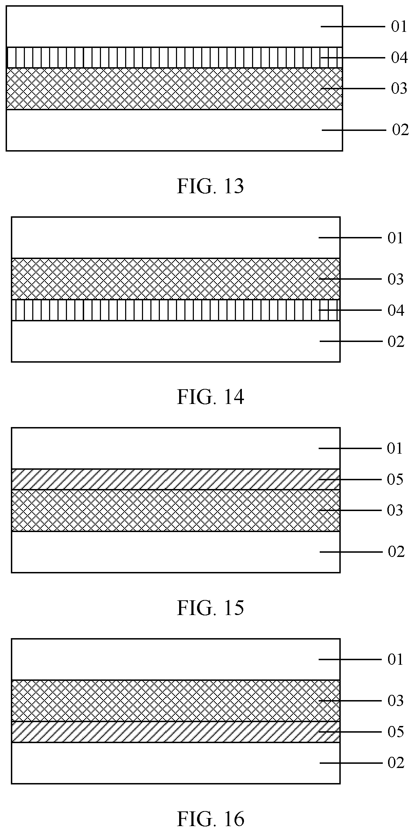

Refer to FIG. 11 to FIG. 16. In an embodiment of this application, the oxygen blocking layer 05 and/or the oxygen storage layer 04 may be inserted only into a single-side of the ferroelectric layer 03. In this way, it is not prone to form an oxygen vacancy defect path on the side of the ferroelectric layer 03, probability of breakdown may further be reduced, and endurance reliability is improved. For example, as shown in FIG. 11 and FIG. 12, both the oxygen blocking layer 05 and the oxygen storage layer 04 may be inserted into the side of the ferroelectric layer 03. Specifically, the second electrode 02, the ferroelectric layer 03, the oxygen storage layer 04, the oxygen blocking layer 05, and the first electrode 01 may be deposited in sequence in a thin film deposition manner, for example, PVD, CVD, or ALD, to obtain the ferroelectric memory cell as shown in FIG. 11. Alternatively, the second electrode 02, the oxygen blocking layer 05, the oxygen storage layer 04, the ferroelectric layer 03, and the first electrode 01 may be deposited in sequence in a thin film deposition manner, for example, PVD, CVD, or ALD, to obtain the ferroelectric memory cell as shown in FIG. 12. For another example, as shown in FIG. 13 and FIG. 14, only the oxygen storage layer 04 may be inserted into the side of the ferroelectric layer 03. Specifically, the second electrode 02, the ferroelectric layer 03, the oxygen storage layer 04, and the first electrode 01 may be deposited in sequence in a thin film deposition manner, for example, PVD, CVD, or ALD, to obtain the ferroelectric memory cell as shown in FIG. 13. Alternatively, the second electrode 02, the oxygen storage layer 04, the ferroelectric layer 03, and the first electrode 01 may be deposited in sequence in a thin film deposition manner, for example, PVD, CVD, or ALD, to obtain the ferroelectric memory cell as shown in FIG. 14. For another example, as shown in FIG. 15 and FIG. 16, only the oxygen blocking layer 05 may be inserted into the side of the ferroelectric layer 03. Specifically, the second electrode 02, the ferroelectric layer 03, the oxygen blocking layer 05, and the first electrode 01 may be deposited in sequence in a thin film deposition manner, for example, PVD, CVD, or ALD, to obtain the ferroelectric memory cell as shown in FIG. 15. Alternatively, the second electrode 02, the oxygen blocking layer 05, the ferroelectric layer 03, and the first electrode 01 may be deposited in sequence in a thin film deposition manner, for example, PVD, CVD, or ALD, to obtain the ferroelectric memory cell as shown in FIG. 16.

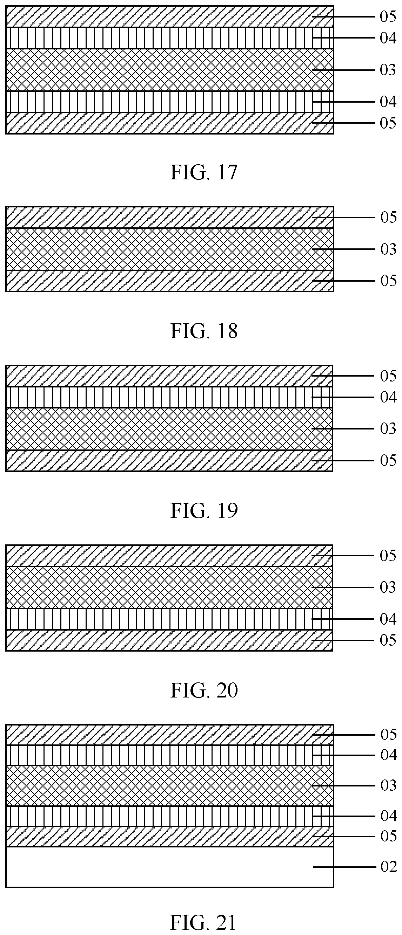

Refer to FIG. 17 to FIG. 36. In an embodiment of this application, because the resistivity of the oxygen blocking layer 05 is closer to the resistivity of the metal, the oxygen blocking layer 05 that is reused as an electrode is disposed on at least one side of the ferroelectric layer 03, that is, the first electrode 01 and/or the second electrode 02 are discarded, and the electrode is replaced with the conductive property of the oxygen blocking layer 05.

Refer to FIG. 17 to FIG. 20. In an embodiment of this application, when oxygen blocking layers 05 are inserted into the two sides of the ferroelectric layer 03, the oxygen blocking layer 05 may replace the first electrode 01 and the second electrode 02. For example, as shown in FIG. 17 and FIG. 18, the film layers inserted into the two sides of the ferroelectric layer 03 may be symmetrically disposed. Specifically, the oxygen blocking layer 05, the oxygen storage layer 04, the ferroelectric layer 03, the oxygen storage layer 04, and the oxygen blocking layer 05 may be deposited in sequence in a thin film deposition manner, for example, PVD, CVD, or ALD, to obtain the ferroelectric memory cell as shown in FIG. 17. Alternatively, the oxygen blocking layer 05, the ferroelectric layer 03, and the oxygen blocking layer 05 may be deposited in sequence in a thin film deposition manner, for example, PVD, CVD, or ALD, to obtain the ferroelectric memory cell as shown in FIG. 18. For another example, as shown in FIG. 19 and FIG. 20, the film layers inserted into the two sides of the ferroelectric layer 03 may be asymmetrically disposed. Specifically, the oxygen blocking layer 05, the ferroelectric layer 03, the oxygen storage layer 04, and the oxygen blocking layer 05 may be deposited in sequence in a thin film deposition manner, for example, PVD, CVD, or ALD, to obtain the ferroelectric memory cell as shown in FIG. 19. Alternatively, the oxygen blocking layer 05, the oxygen storage layer 04, the ferroelectric layer 03, and the oxygen blocking layer 05 may be deposited in sequence in a thin film deposition manner, for example, PVD, CVD, or ALD, to obtain the ferroelectric memory cell as shown in FIG. 20.

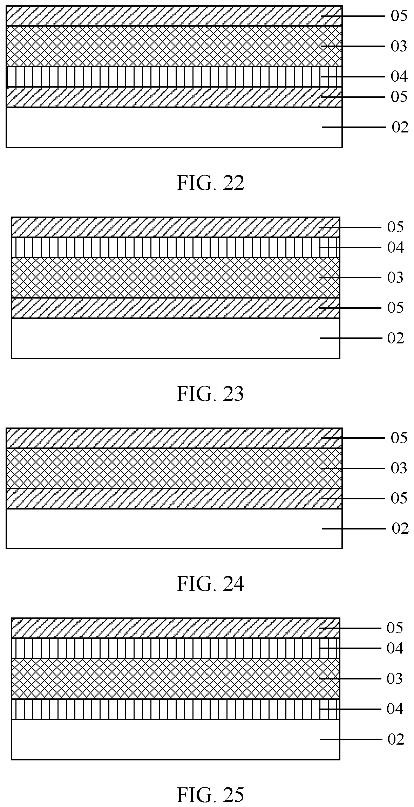

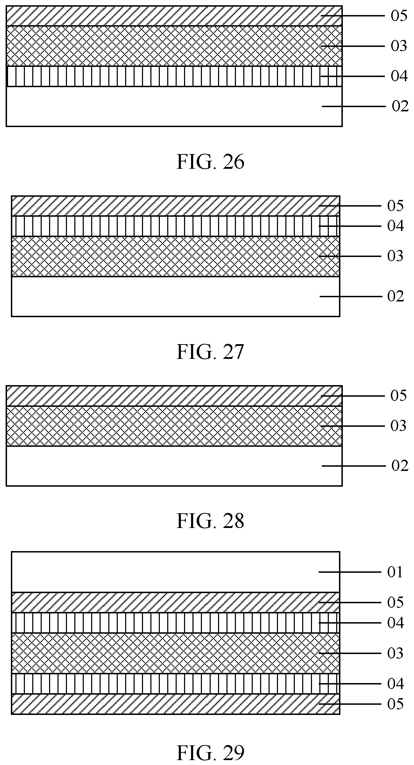

Refer to FIG. 21 to FIG. 28. In an embodiment of this application, the oxygen blocking layer 05 inserted into the side that is of the ferroelectric layer 03 and that is close to the first electrode 01 may replace the first electrode 01. For example, as shown in FIG. 21 to FIG. 24, the oxygen blocking layer 05 may also be inserted into the side that is of the ferroelectric layer 03 and that is close to the second electrode 02, but the second electrode 02 may be disposed at the same time. Specifically, the second electrode 02, the oxygen blocking layer 05, the oxygen storage layer 04, the ferroelectric layer 03, the oxygen storage layer 04, and the oxygen blocking layer 05 may be deposited in sequence in a thin film deposition manner, for example, PVD, CVD, or ALD, to obtain the ferroelectric memory cell as shown in FIG. 21. Alternatively, the second electrode 02, the oxygen blocking layer 05, the oxygen storage layer 04, the ferroelectric layer 03, and the oxygen blocking layer 05 may be deposited in sequence in a thin film deposition manner, for example, PVD, CVD, or ALD, to obtain the ferroelectric memory cell as shown in FIG. 22. Alternatively, the second electrode 02, the oxygen blocking layer 05, the ferroelectric layer 03, the oxygen storage layer 04, and the oxygen blocking layer 05 may be deposited in sequence in a thin film deposition manner, for example, PVD, CVD, or ALD, to obtain the ferroelectric memory cell as shown in FIG. 23. Alternatively, the second electrode 02, the oxygen blocking layer 05, the ferroelectric layer 03, and the oxygen blocking layer 05 may be deposited in sequence in a thin film deposition manner, for example, PVD, CVD, or ALD, to obtain the ferroelectric memory cell as shown in FIG. 24. For another example, as shown in FIG. 25 to FIG. 28, the oxygen blocking layer 05 may not be inserted into the side that is of the ferroelectric layer 03 and that is close to the second electrode 02. Specifically, the second electrode 02, the oxygen storage layer 04, the ferroelectric layer 03, the oxygen storage layer 04, and the oxygen blocking layer 05 may be deposited in sequence in a thin film deposition manner, for example, PVD, CVD, or ALD, to obtain the ferroelectric memory cell as shown in FIG. 25. Alternatively, the second electrode 02, the oxygen storage layer 04, the ferroelectric layer 03, and the oxygen blocking layer 05 may be deposited in sequence in a thin film deposition manner, for example, PVD, CVD, or ALD, to obtain the ferroelectric memory cell as shown in FIG. 26. Alternatively, the second electrode 02, the ferroelectric layer 03, the oxygen storage layer 04, and the oxygen blocking layer 05 may be deposited in sequence in a thin film deposition manner, for example, PVD, CVD, or ALD, to obtain the ferroelectric memory cell as shown in FIG. 27. Alternatively, the second electrode 02, the ferroelectric layer 03, and the oxygen blocking layer 05 may be deposited in sequence in a thin film deposition manner, for example, PVD, CVD, or ALD, to obtain the ferroelectric memory cell as shown in FIG. 28.

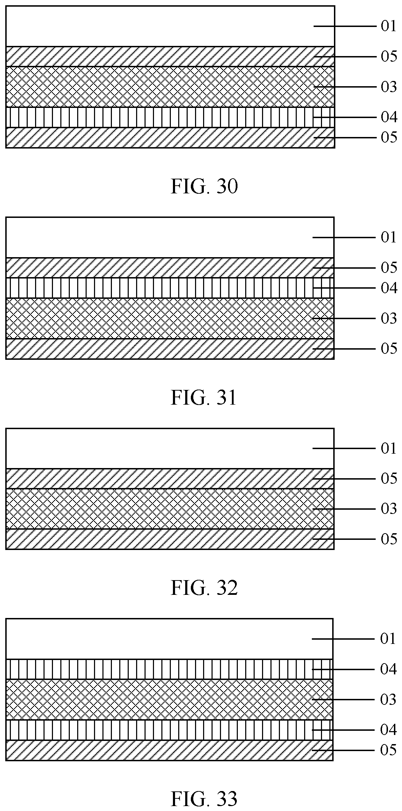

Refer to FIG. 29 to FIG. 36. In an embodiment of this application, the oxygen blocking layer 05 inserted into the side that is of the ferroelectric layer 03 and that is close to the second electrode 02 may replace the second electrode 02. For example, as shown in FIG. 29 to FIG. 32, the oxygen blocking layer 05 may also be inserted into the side that is of the ferroelectric layer 03 and that is close to the first electrode 01, but the first electrode 01 may be disposed at the same time. Specifically, the oxygen blocking layer 05, the oxygen storage layer 04, the ferroelectric layer 03, the oxygen storage layer 04, the oxygen blocking layer 05, and the first electrode 01 may be deposited in sequence in a thin film deposition manner, for example, PVD, CVD, or ALD, to obtain the ferroelectric memory cell as shown in FIG. 29. Alternatively, the oxygen blocking layer 05, the oxygen storage layer 04, the ferroelectric layer 03, the oxygen blocking layer 05, and the first electrode 01 may be deposited in sequence in a thin film deposition manner, for example, PVD, CVD, or ALD, to obtain the ferroelectric memory cell as shown in FIG. 30. Alternatively, the oxygen blocking layer 05, the ferroelectric layer 03, the oxygen storage layer 04, the oxygen blocking layer 05, and the first electrode 01 may be deposited in sequence in a thin film deposition manner, for example, PVD, CVD, or ALD, to obtain the ferroelectric memory cell as shown in FIG. 31. Alternatively, the oxygen blocking layer 05, the ferroelectric layer 03, the oxygen blocking layer 05, and the first electrode 01 may be deposited in sequence in a thin film deposition manner, for example, PVD, CVD, or ALD, to obtain the ferroelectric memory cell as shown in FIG. 32. For another example, as shown in FIG. 33 to FIG. 36, the oxygen blocking layer 05 may not be inserted into the side that is of the ferroelectric layer 03 and that is close to the first electrode 01. Specifically, the oxygen blocking layer 05, the oxygen storage layer 04, the ferroelectric layer 03, the oxygen storage layer 04, and the first electrode 01 may be deposited in sequence in a thin film deposition manner, for example, PVD, CVD, or ALD, to obtain the ferroelectric memory cell as shown in FIG. 33. Alternatively, the oxygen blocking layer 05, the oxygen storage layer 04, the ferroelectric layer 03, and the first electrode 01 may be deposited in sequence in a thin film deposition manner, for example, PVD, CVD, or ALD, to obtain the ferroelectric memory cell as shown in FIG. 34. Alternatively, the oxygen blocking layer 05, the ferroelectric layer 03, the oxygen storage layer 04, and the first electrode 01 may be deposited in sequence in a thin film deposition manner, for example, PVD, CVD, or ALD, to obtain the ferroelectric memory cell as shown in FIG. 35. Alternatively, the oxygen blocking layer 05, the ferroelectric layer 03, and the first electrode 01 may be deposited in sequence in a thin film deposition manner, for example, PVD, CVD, or ALD, to obtain the ferroelectric memory cell as shown in FIG. 36.

According to the ferroelectric memory cell provided in embodiments of this application, after the oxygen blocking layer 05 and/or the oxygen storage layer 04 are/is added, a depolarization field caused by an interface oxygen vacancy is reduced, so that a coercive electric field of the ferroelectric layer 03 is lower. Refer to Table 1. For a 6 nm-thinned ferroelectric memory cell, an operating voltage may be reduced from a range of 1.8 V to 2.4 V to a range of 1.2 V to 1.5 V, and the operating voltage is reduced by 30%, thereby greatly reducing power consumption and achieving an objective of low power consumption and energy saving. In addition, after the oxygen blocking layer 05 and/or the oxygen storage layer 04 are/is added, a bias electric field introduced by an oxygen vacancy may be reduced, and a memory capability of a device at a high temperature is also improved, thereby greatly reducing memory loss of ferroelectric polarization. After industrial-grade 85°C high-temperature baking, a forward read window of the ferroelectric memory cell provided in embodiments of this application can be reduced from 30% memory loss to zero memory loss, thereby meeting a 10-year memory requirement. However, at an automobile-grade 105°C high temperature, the ferroelectric memory cell provided in embodiments of this application can also meet a 10-year memory requirement. In addition, after the oxygen blocking layer 05 and/or the oxygen storage layer 04 are/is added, the coercive electric field (E_{C}) is reduced, and a breakdown electric field (E_{BD}) resistance capability is increased. Therefore, a ratio of EC to EBD is further reduced. When a same operating voltage is used, endurance of the ferroelectric layer 03 is directly improved, and because of a low coercive electric field, there is space for further reducing the operating electric field, to obtain a greater endurance (endurance) benefit.

In conclusion, the ferroelectric memory cell provided in embodiments of this application is improved in terms of the low operating electric field, the memory capability, and the endurance.

**Table 1: Performance comparison of the 6 nm-thinned ferroelectric memory cell**

| Device performance | Existing ferroelectric memory cell | Ferroelectric memory cell in this application |
|---|---|---|
| Coercive electric field E_{C} | >1.6 MV/cm | 1.1 MV/cm |
| Operating electric field | 3 MV/cm to 4 MV/cm | 2 MV/cm to 2.5 MV/cm |
| Operating voltage | 1.8 V to 2.4 V | 1.2 V to 1.5 V |
| Industrial-grade 85°C 1.8 V read loss (SS polarization decrease (%)) | 30% loss | About 0% loss |
| Automobile-grade 105°C 1.8 V read loss (SS polarization decrease (%)) | N/A | 4% loss |
| Breakdown electric field (E_{BD}) | 4.2 MV/cm | 5.25 MV/cm |
| Endurance | 1e8 cycles breakdown (1.84 V operating voltage) | 1e9 cycles breakdown (2.0 V operating voltage) |

Correspondingly, this application further provides a memory, including a plurality of ferroelectric memory cells and a control circuit electrically connected to each ferroelectric memory cell. Specifically, a voltage may be applied to the ferroelectric memory cell via the control circuit, to control the ferroelectric memory cell to implement a read/write operation. The ferroelectric memory cell may be the ferroelectric memory cell provided in any one of the foregoing embodiments of this application.

Correspondingly, this application further provides an electronic device, including a circuit board and a memory coupled to the circuit board. The electronic device may be an electronic device, for example, a mobile phone, a tablet computer, a notebook computer, a wearable device, or an in-vehicle device, or certainly may be another electronic device. This is not limited herein.

It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. A ferroelectric memory cell, comprising a ferroelectric layer, and at least one first oxygen storage layer and at least one first oxygen blocking layer that are located on one side of the ferroelectric layer, wherein the at least one first oxygen storage layer is adjacent to the ferroelectric layer, the first oxygen storage layer comprises conductive oxide, the first oxygen blocking layer comprises a conductive compound, and an electrical conductivity of the first oxygen blocking layer is greater than an electrical conductivity of the first oxygen storage layer.

2. The ferroelectric memory cell according to claim 1, further comprising:
at least one second oxygen storage layer located on the other side of the ferroelectric layer; or
at least one second oxygen blocking layer located on the other side of the ferroelectric layer; or
at least one storage layer of second oxygen and at least one second oxygen blocking layer that are located on the other side of the ferroelectric layer, wherein the at least one second oxygen storage layer is adjacent to the ferroelectric layer; and
the second oxygen storage layer comprises conductive oxide, the second oxygen blocking layer comprises a conductive compound, and an electrical conductivity of the second oxygen blocking layer is greater than an electrical conductivity of the second oxygen storage layer.

3. The ferroelectric memory cell according to claim 2, further comprising: a first electrode and a second electrode that are disposed opposite to each other, wherein the ferroelectric layer, the first oxygen storage layer, the second oxygen storage layer, the first oxygen blocking layer, and the second oxygen blocking layer are all located between the first electrode and the second electrode.

4. The ferroelectric memory cell according to claim 1 or 2, wherein the first oxygen blocking layer located on the side of the ferroelectric layer is reused as an electrode.

5. The ferroelectric memory cell according to claim 2, wherein the second oxygen blocking layer located on the other side of the ferroelectric layer is reused as an electrode.

6. The ferroelectric memory cell according to any one of claims 1 to 5, wherein resistivities of the first oxygen blocking layer and the second oxygen blocking layer are from 1×10⁻⁷ Ω·m to 1×10⁻³ Ω·m.

7. The ferroelectric memory cell according to any one of claims 1 to 6, wherein resistivities of the first oxygen storage layer and the second oxygen storage layer are from 1×10⁻⁴ Ω·m to 1×10⁴ Ω·m.

8. The ferroelectric memory cell according to any one of claims 1 to 7, wherein materials of the first oxygen storage layer and the second oxygen storage layer comprise niobium oxide, ruthenium oxide, or titanium oxide.

9. The ferroelectric memory cell according to any one of claims 1 to 8, wherein materials of the first oxygen blocking layer and the second oxygen blocking layer comprise tungsten nitride, titanium nitride, or tantalum nitride.

10. The ferroelectric memory cell according to claim 3, wherein materials of the first electrode and the second electrode comprise tungsten, titanium, copper, aluminum, ruthenium, platinum, iridium, tungsten nitride, titanium nitride, or tantalum nitride.

11. The ferroelectric memory cell according to any one of claims 1 to 10, wherein a material of the ferroelectric layer comprises at least one of hafnium oxide, zirconium oxide, or hafnium zirconium oxide; or hafnium oxide, zirconium oxide, or hafnium zirconium oxide doped with at least one of La, Gd, Y, Al, Sr, Ce, or Ti.

12. The ferroelectric memory cell according to claim 11, wherein the ferroelectric layer comprises: an alloy structure of single-layer molecules of hafnium oxide and zirconium oxide, or a laminated structure in which hafnium oxide and zirconium oxide are alternated, or a laminated structure in which Hf-rich hafnium zirconium oxide and Zr-rich hafnium zirconium oxide are alternated.

13. A memory, comprising a plurality of ferroelectric memory cells according to any one of claims 1 to 12 and a control circuit electrically connected to each of the ferroelectric memory cells.

14. An electronic device, comprising a circuit board, and the memory according to claim 13 that is coupled to the circuit board.
